# EUROPÄISCHE PATENTSCHRIFT

(11) **EP 3 444 574 B1**
(45) Veröffentlichungstag und Bekanntmachung des Hinweises auf die Patenterteilung: **19.02.2020**
(21) Anmeldenummer: 18188736.5
(22) Anmeldetag: 13.08.2018
(51) Int. Cl.: G01F 1/66, H01L 41/053, G10K 9/22, H02N 2/04, H02N 2/00, G10K 9/122, H04R 17/00, B06B 1/06

(54) **SCHALLKOPF FÜR EINEN DURCHFLUSSMESSER MIT GESTUFTER SEITENWAND**
SOUNDER HEAD FOR A FLOW METER WITH STEPPED SIDE WALL
TÊTE À ULTRASONS POUR UN DÉBITMÈTRE DOTÉE D'UNE PAROI LATÉRALE ÉTAGÉE

(30) Priorität: 17.08.2017 DE 102017214370
(43) Veröffentlichungstag der Anmeldung: 20.02.2019
(73) Patentinhaber: Landis+Gyr GmbH, 90459 Nürnberg (DE)
(72) Erfinder: Faißt, Andreas, 90461 Nürnberg (DE); Herold, Peter, 90459 Nürnberg (DE)
(74) Vertreter: Rau, Schneck & Hübner Patentanwälte Rechtsanwälte PartGmbB

(56) Entgegenhaltungen:
- US-A1- 2006 288 775
- US-A1- 2010 011 866

## Beschreibung

Die Erfindung betrifft einen Schallkopf zum Einbau in ein Messrohr eines Durchflussmessers zur schallbasierten Erfassung einer Durchflussmenge eines Mediums aufweisend eine Längsachse.

Durchflussmesser auf Grundlage der (Ultra-)Schallmesstechnik sind bekannt. Impulsförmige (Ultra-)Schallsignale werden mittels (Ultra-) Schallwandler erzeugt sowie in Flussrichtung und entgegen der Flussrichtung durch das Medium gesendet. Der Unterschied der Laufzeiten der Schallsignale in beiden Laufrichtungen wird zur Ermittlung der Durchflussmenge des Mediums ausgewertet. Derartige ultraschallbasierte Durchflussmesser arbeiten nach dem Laufzeitdifferenzprinzip.

Es gibt verschiedene Ausgestaltungen. Zum einen sind Einrichtungen bekannt, die Durchflussmesser im eigentlichen Sinne darstellen und ausschließlich die Durchflussmenge des Mediums ermitteln. Zum anderen gibt es auch Energiezähler, beispielsweise in Form von Wärme- und Kältezählern, bei denen die nach dem vorstehend erläuterten Prinzip ermittelte Durchflussmenge mit mindestens einem zusätzlich Temperaturmesswert in Verbindung gebracht wird, um so die über das Medium zugeführte (Wärme- oder Kälte-) Energie zu bestimmen. Auch derartige Energiezähler sind hier als - speziell ausgestaltete - Durchflussmesser zu verstehen.

Die zur Schallerzeugung und zum Schallempfang eingesetzten Schallwandler können je nach Bauform des Durchflussmessers auch in gesonderten Bauteilen eingebaut sein. So kann sich der Schallwandler beispielsweise in einem gesonderten Gehäuse befinden. Eine solche Einheit aus Gehäuse mit darin platziertem Schallwandler wird hier auch als Schallkopf bezeichnet. Bei bekannten Schallkopf-Bauformen kann das Gehäuse sehr stabil ausgeführt sein, beispielsweise als Messingbauteil. Dann kann der Schallkopf zwar sehr hohen Druckbelastungen durch das zu erfassende Medium standhalten. Andererseits resultieren aber auch vergleichsweise hohen Herstellungskosten und ein hohes Gewicht.

In der DE 10 2009 046 147 A1, DE 10 2009 046 148 A1 und der DE 10 2010 000 967 A1 werden andere Bauformen von Schallköpfen beschrieben, bei denen das den jeweiligen Schallwandler aufnehmende Gehäuse an seiner dem zu beschallenden Medium zugewandten Seite offen und lediglich mit einer Abdichtfolie abgedeckt bzw. verschlossen ist. Diese Schallköpfe sind vor allem zum Einsatz in gasförmigen Medien, insbesondere in der Umgebungsluft, bestimmt. Jedenfalls sind diese Schallköpfe keinen hohen Druckbelastungen ausgesetzt, welchen die eingesetzten Abdichtfolien andernfalls nicht standhalten könnten.

In der US 2010/0011866 A1 wird ein weiterer Schallkopf zur Verwendung in einem Durchflussmesser beschrieben. Er hat einen Topf mit einer Topfseitenwand, einem zu durchschallenden Topfboden und einer Topföffnung. Ein als Piezo-Kristall ausgebildetes Wandlerelement ist auf der Innenseite des Topfbodens platziert. Die Topfseitenwand hat einen bereichsweise mäanderförmig verlaufenden Wandquerschnitt, wodurch zwei Resonatoren gebildet sind, welche die Übertragung von Gehäusewellen verhindern sollen. In die Resonatoren kann ein Dämpfungskörper aus einem viskoelastischen Material eingesetzt sein.

In der US 2006/0288775 A1 wird ein Schallkopf einer Einheit zur reflexionsbasierten Bestimmung der Kraftstoff-Füllhöhe in einem Kraftstofftank beschrieben. Der Schallkopf befindet sich am Boden des Tanks. Er hat einen lose auf einem Topfboden platzierten Ultraschallsensor, wobei sich Kraftstoff innerhalb des mit entsprechenden Durchtrittsöffnungen versehenen Topfs befindet.

Obwohl bereits viele Bauformen von Schallköpfen bekannt sind, besteht weiterhin Bedarf an verbesserten Lösungen im Hinblick auf die Handhabung, Bedien-/Betriebssicherheit, Eignung zur automatisierten Massenfertigung und/oder Herstellungskosten derartiger Bauteile.

Die Aufgabe der Erfindung besteht darin, einen Schallkopf für einen Einbau in einen Durchflussmesser anzugeben, der gegenüber den bekannten Ausgestaltungen weiter verbessert ist.

Der Umfang der Erfindung wird durch die Ansprüche definiert.

Zur Lösung dieser Aufgabe wird ein Schallkopf entsprechend den Merkmalen des Patentanspruchs 1 angegeben. Der erfindungsgemäße Schallkopf hat einen Topf aus einem metallischen Topfmaterial mit einer Topfseitenwand, einem zu durchschallenden Topfboden und einer dem Topfboden gegenüberliegenden Topföffnung, ein elektromechanisches Schallwandlungselement, das auf eine Innenseite des Topfbodens geklebt ist, zwei aus der Topföffnung herausführende elektrische Zuleitungen zur elektrischen Kontaktierung des elektromechanischen Schallwandlungselements, und ein Verschlussteil, das in den Topf eingesetzt ist und die Topföffnung verschließt. Dabei mündet die Topfseitenwand auf Höhe der Topföffnung in einen umgebogenen Topf-Randbereich, welcher sich in seitliche Richtung weg von der Längsachse erstreckt. Außerdem weist die Topfseitenwand eine Topfstufe und das Verschlussteil in einer Verschlussteilseitenwand eine zur Topfstufe korrespondierende Verschlussteilstufe auf, wobei die Topfstufe und die Verschlussteilstufe unmittelbar aneinander anliegen. Weiterhin hat das Verschlussteil erfindungsgemäß einen seitlich vorstehenden und komplett umlaufenden Verbindungskragen, der mit dem umgebogenen Topf-Randbereich der Topfseitenwand fest verbunden ist. Darüber hinaus kapselt der Topf im in ein Messrohr eingebauten Zustand des Schallkopfs die Innenseite des Topfs von dem Medium ab.

Der Topf ist insbesondere ein tiefgezogenes Bauteil und lässt sich dementsprechend kostengünstig fertigen. Das Topfmaterial ist außerdem vorzugsweise elektrisch leitfähig. Es ist insbesondere ein Metall und besteht z.B. aus einem Edelstahl oder weist zumindest einen Edelstahl-Anteil auf. Weiterhin ist der Topf insbesondere einstückig ausgebildet. So sind vor allem die Topfseitenwand und der Topfboden einstückig miteinander verbunden. Sie bestehen aus dem gleichen Material. Dementsprechend liegt zwischen ihnen eine Stoffverbindung vor. Weiterhin ist der Topf erfindungsgemäß an seiner Unterseite, die beim Einbau des Schallkopfs in ein Messrohr dem zu erfassenden Medium zugewandt ist und insbesondere mit dem Medium auch in direkten Kontakt kommt, durch den Topfboden geschlossen. Im eingebauten Zustand kapselt der Topf die Innenseite des Topfs und die darin befindlichen Komponenten, insbesondere - aber nicht nur - das elektromechanische Schallwandlungselement, sicher von dem zu erfassenden bzw. zu beschallenden Medium ab.

Das elektromechanische Schallwandlungselement ist vorzugsweise auf die Innenseite des Topfbodens geklebt. Dadurch wird insbesondere erreicht, dass der Topfboden im Wesentlich gemeinsam mit dem elektromechanischen Schallwandlungselement schwingt und dass somit Schallenergie über den Topfboden in das Medium abgestrahlt wird und umgekehrt auch vom Medium zum Schallwandlungselement übertragen wird. Der Topfboden und das ein- bzw. aufgeklebte elektromechanische Schallwandlungselement bilden insofern eine günstige Schall-Kombinationseinheit.

Insbesondere handelt es sich bei dem Medium, dessen Durchflussmenge mittels des Schallkopfs zu erfassen ist, um ein flüssiges Medium, vorzugsweise um Wasser. Der Schallkopf ist zur Erfassung der Durchflussmenge des Mediums insbesondere dazu ausgelegt, dieses Medium zu beschallen.

Die vorteilhafterweise gestuft ausgebildete Topfseitenwand bietet im Zusammenspiel mit der ebenfalls vorteilhafterweise gestuft ausgebildeten Verschlussteilseitenwand eine besonders hohe Widerstandsfähigkeit gegenüber hohen Druckbeaufschlagungen, die sich während des Betriebs aufgrund des Kontakts mit dem Medium ergeben können. Insbesondere ist das Medium eine in einem Rohrsystem transportierte Flüssigkeit, wodurch durchaus beträchtliche Druckbelastungen durch das Medium auf den Schallkopf übertragen werden können. Der Schallkopf ist vorzugsweise für einen Einsatz in einem solchen (ggf. unter hohem Druck stehenden) flüssigen Medium ausgelegt. Die aneinander anliegenden Stufen, also die Topfstufe und die dazu korrespondierende Verschlussteilstufe, nehmen günstigerweise die Druckbelastungen auf und leiten sie ab, so dass das auf dem Topfboden platzierte elektromechanische Schallwandlungselement vor mechanischen Beschädigungen geschützt wird.

Weiterhin dienen die aneinander anliegenden Stufen während der Herstellung des Schallkopfs vorteilhafterweise als Endanschlag dafür, wie weit das Verschlussteil in den Topf einzusetzen ist. Auf diese Weise können die konstruktiven Vorgaben sehr einfach und vor allem sehr zuverlässig eingehalten werden. Insbesondere ist somit problemlos gewährleistet, dass das Verschlussteil (direkt oder indirekt) den genau gewünschten Druck auf das elektromechanische Schallwandlungselement ausübt, und/oder dass eine erste Klebstoffschicht zwischen dem elektromechanischen Schallwandlungselement und dem Topfboden die gewünschte Schichtdicke aufweist.

Außerdem kann die Außenseite der Topfstufe dazu verwendet werden, dass auf die Stufenkante die Haltestege eines Schallreflektors, der ein vom Schallkopf ausgehendes Schallsignal oder ein eintreffendes Schallsignal auf den Schallkopf umlenkt, aufgesetzt sind. Die Topfstufe ist also insbesondere auch eine Ansatz- oder Befestigungsstelle für einen solchen Schallreflektor.

Dadurch, dass der seitlich vorstehende und komplett umlaufende Verbindungskragen des Verschlussteils mit dem umgeformten bzw. umgebogenen Topf-Randbereich der Topfseitenwand fest verbunden ist, wird ein sehr guter Schutz gegen äußere Störeinflüsse erreicht. Insbesondere ist die Verbindung sehr dicht gegenüber einem Eindringen von Staub, Schmutz und/oder Wasser oder anderen Flüssigkeiten.

Vorteilhafte Ausgestaltungen des erfindungsgemäßen Schallkopfs ergeben sich aus den Merkmalen der von Anspruch 1 abhängigen Ansprüche.

Günstig ist eine Ausgestaltung, bei der das Verschlussteil so innerhalb des Topfs platziert ist, dass es Druck auf das elektromechanische Schallwandlungselement ausübt. Diese Druckausübung kann insbesondere direkt oder indirekt, beispielsweise mittels eines insbesondere komprimierbaren Dämpfungskörpers, erfolgen. Dadurch ergibt sich ein dauerhaft stabiler Aufbau, der über einen langen Zeitraum eine gleichbleibend gute Funktionalität des Schallkopfs gewährleistet. Die Druckbeaufschlagung sorgt außerdem für eine konstante Dämpfung und einen kontrollierten Fertigungsprozess.

Vorzugsweise ist die Verbindung zwischen dem Verbindungskragen und dem Randbereich der Topfseitenwand eine Klebeverbindung oder eine Schweißverbindung. Dadurch wird ein sehr guter Schutz gegen äußere Störeinflüsse erreicht. Insbesondere ist die Verbindung sehr dicht gegenüber einem Eindringen von Staub, Schmutz und/oder Wasser oder anderen Flüssigkeiten.

Gemäß einer weiteren günstigen Ausgestaltung hat das Verschlussteil einen Kunststoff-Hauptkörper und ein Verstärkungsblech, wobei das Verstärkungsblech zumindest zu einem Teil in dem Kunststoff-Hauptkörper eingebettet ist. Der Topf hat insbesondere eine Topfwanddicke im Bereich zwischen 0,1 mm und 1 mm, vorzugsweise zwischen 0,2 mm und 0,5 mm. Diese Dickenwerte gelten insbesondere sowohl für die Topfseitenwand als auch für den Topfboden. Jedenfalls handelt es sich um keine besonders große Topfwanddicke. Insofern ist der Topf insbesondere auch nur begrenzt mechanisch belastbar. Dies gilt insbesondere bei der Ausführungsform als Tiefzieh-Bauteil. Das Verstärkungsblech des Verschlussteils führt insofern zu einer vorteilhaften mechanischen Entlastung des Topfs, insbesondere von dessen Topfseitenwand und/oder von dessen Topfboden. Das Verstärkungsblech hat eine Blechstärke von vorzugsweise im Bereich zwischen 0,5 mm und 5 mm, insbesondere von im Bereich zwischen 0,75 mm und 3 mm. Damit ergibt sich eine sehr wirkungsvolle mechanische Verstärkung sowohl des Topfs als auch des Gesamtaufbaus des Schallkopfs. Letzteres ist insbesondere dann von Vorteil, wenn das mittels des Schallkopfs zu erfassende oder zu beschallende Medium unter hohem Druck steht, beispielsweise im Normalbetrieb unter einem Druck von mehr als 10 bar, vorzugsweise im Bereich zwischen etwa 16 bar und etwa 25 bar. In Sonderbetriebssituationen können bei Durchflussmessern auch Druckspitzen mit noch höheren Druckwerten von insbesondere bis zu 50 bar auftreten. Der Kunststoff-Hauptkörper des Verschlussteils ist - anders als das Verstärkungsblech - nicht primär zur Erhöhung der mechanischen Stabilität vorgesehen, obwohl er grundsätzlich auch hierzu in gewissem Umfang beiträgt. Der Kunststoff-Hauptkörper dient vor allem zum Verschließen der Topföffnung, aber auch zur Führung der elektrischen Zuleitungen und insbesondere auch zum Schutz der freiliegenden Endabschnitte der elektrischen Zuleitungen. Insofern erfüllen das Verstärkungsblech und der Kunststoff-Hauptkörper als die beiden Komponenten des Verschlussteils insbesondere jeweils spezifische und sich unterscheidende Aufgaben, entsprechend denen sie vorzugsweise gezielt ausgelegt sind. Der Kunststoff-Hauptkörper kommt dabei insbesondere auch deshalb zum Einsatz, um verglichen mit einer rein metallischen Ausführungsform Gewicht einzusparen. Deshalb bietet das sich aus zwei Komponenten zusammensetzende Verschlussteil insbesondere Vorteile gegenüber einer einteiligen Ausführungsform mit nur einer Komponente.

Gemäß einer weiteren günstigen Ausgestaltung erstreckt sich das Verstärkungsblech bis in den Verbindungskragen und bildet dort eine Verschlussteil-Verbindungsfläche, die mit einer im Randbereich der Topfseitenwand vorhandenen korrespondierenden Topf-Verbindungsfläche verbunden ist. Damit resultiert vorteilhafterweise eine Verbindung von Metall zu Metall, die sehr stabil und beständig ist. Insbesondere ist der Verbindungskragen im Wesentlichen durch das Verstärkungsblech gebildet. Insbesondere ist die Verschlussteil-Verbindungsfläche ein frei liegender Teil der Oberfläche des Verstärkungsblechs, welches in diesem Bereich unbedeckt, also nicht in das Kunststoffmaterial des Kunststoff-Hauptkörpers eingebettet, ist.

Gemäß einer weiteren günstigen Ausgestaltung ist zur Verklebung zwischen dem elektromechanischen Schallwandlungselement und dem Topfboden eine elektrisch isolierende erste Klebstoffschicht vorhanden. Insbesondere bildet die erste Klebstoffschicht die Verklebung zwischen dem elektromechanischen Schallwandlungselement und dem Topfboden. Während der Verwendung des Schallkopfs in einem Durchflussmesser besteht dann vorteilhafterweise keine elektrisch leitende Verbindung zwischen dem an der Außenseite des insbesondere elektrisch leitfähigen Topfbodens vorbeiströmenden Medium und dem innen auf den Topfboden aufgeklebten elektromechanischen Schallwandlungselement. Dadurch verringert sich die Störanfälligkeit des Messsystems insgesamt. Es kann ein stärkeres Nutzsignal zur Auswertung erzeugt werden. Außerdem vereinfacht die aufgrund der bevorzugt elektrisch isolierend ausgeführten ersten Klebstoffschicht inhärent gegebene galvanische Trennung zwischen dem elektromechanischen Schallwandlungselement inklusive seiner elektrischen Zuleitungen einerseits und dem insbesondere metallischen und damit elektrisch leitfähigen Topf andererseits die elektrische Anbindung des Schallkopfs an eine Energieversorgung und/oder an eine Ansteuer-/Auswerteeinheit. Das ansonsten in einer solchen elektrischen Anbindung vorhandene Zusatzbauteil zur galvanischen Trennung, z.B. ein Optokoppler, kann entfallen, was Kostenvorteile für ein mit dem Schallkopf realisiertes Gesamtmesssystem bietet.

Gemäß einer weiteren günstigen Ausgestaltung weist die elektrisch isolierende erste Klebstoffschicht mechanisch stabile Abstandshalteelemente, insbesondere in Form von Glaskügelchen, auf. Diese Glaskügelchen sind insbesondere ebenfalls elektrisch isolierend. Sie gewährleisten, dass ein gewünschter Mindest-Isolationsabstand zwischen dem elektromechanischen Schallwandlungselement und dem Topfboden vorzugsweise überall gegeben ist. Die Abstandshalteelemente kann man insbesondere auch als "Spacer" bezeichnen.

Gemäß einer weiteren günstigen Ausgestaltung weist die elektrisch isolierende erste Klebstoffschicht überall eine Schichtdicke im Bereich zwischen 5 µm und 300 µm, insbesondere zwischen 10 µm und 200 µm, auf. Dadurch wird ein sehr guter Kompromiss zwischen zwei gegenläufigen Tendenzen erreicht. Je größer die Schichtdicke der ersten Klebstoffschicht ist, desto stabiler sind die mechanischen Eigenschaften. Andererseits erschwert oder verhindert eine zu dicke erste Klebstoffschicht eine für die Schall erzeugende und empfangende Hauptfunktion des Schallkopfs maßgebliche Schwingungsfähigkeit des elektromechanischen Schallwandlungselements bzw. des verklebten Verbunds aus dem elektromechanischen Schallwandlungselement und dem Topfboden. Schichtdicken aus den vorstehend genannten Wertebereichen werden beiden Aspekten gleichermaßen sehr gut gerecht.

Gemäß einer weiteren günstigen Ausgestaltung sind das Verschlussteil und die Topfseitenwand mittels einer zweiten Klebstoffschicht miteinander verbunden. Diese zweite Klebstoffschicht dient dem Schutz vor Eindringen von Staub, anderem Schmutz, Wasser, anderen Flüssigkeiten und/oder Gasen in den Topfinnenraum, in dem sich die maßgeblichen Komponenten des Schallkopfs befinden. Außerdem ist der Schallkopf aufgrund der Verklebung zwischen dem Verschlussteil und der Topfseitenwand mittels der zweiten Klebstoffschicht ein insbesondere nicht zerlegbares Kombinationsbauteil. Letzteres lässt sich einfacher und mit einer geringeren Fehleranfälligkeit handhaben und weiter verbauen.

Gemäß einer weiteren günstigen Ausgestaltung weisen die erste und die zweite Klebstoffschicht die gleichen Härtungsbedingungen, insbesondere die gleiche Härtungszeit, die gleiche Härtungstemperatur und den gleichen Härtungsdruck, auf. Beide Klebstoffschichten können dann vorteilhafterweise gleichzeitig ausgehärtet werden, was die Produktionszeit verkürzt. Die erste und die zweite Klebstoffschicht können beispielsweise aus einem Epoxid-Kleber bestehen oder eine solche Materialkomponente aufweisen. Es ist möglich, aber nicht zwingend erforderlich, dass beide Klebstoffschichten aus dem gleichen Klebstoff bestehen oder zumindest auf dem gleichen Klebstoff basieren. Ein denkbarer Unterschied ist, dass die zweite Klebstoffschicht im Gegensatz zur ersten Klebstoffschicht keine Zusatzkomponente in Form der Abstandshalteelemente aufweist. Die zweite Klebstoffschicht kann zwar ebenfalls elektrisch isolierend ausgeführt sein. Dies ist aber nicht unbedingt erforderlich und bietet keine vergleichbaren Vorteile wie bei der ersten Klebstoffschicht.

Gemäß einer weiteren günstigen Ausgestaltung weist das Verschlussteil auf einer von dem elektromechanischen Schallwandlungselement abgewandten Seite einen Schutzkragen auf, welcher über die verschlossene Topföffnung vorsteht und die elektrischen Zuleitungen umgibt, wobei der Schutzkragen insbesondere mit Ausziehmitteln ausgestattet ist. Der Schutzkragen ist insbesondere Bestandteil des Kunststoff-Hauptkörpers und ist vorzugsweise auf einer von dem elektromechanischen Schallwandlungselement abgewandten Seite des Verstärkungsblechs angeordnet. Vorteilhafterweise schützt der Schutzkragen die von ihm umgebenen Endabschnitte der elektrischen Zuleitungen. Insbesondere reicht der Schutzkragen in axialer Richtung, also in Richtung der Längsachse des Schallkopfs, zumindest in etwa genauso weit wie die freiliegenden Enden der elektrischen Zuleitungen, welche damit im Wesentlichen vollständig vom Schutzkragen umgeben sind. Der Schutzkragen verhindert insbesondere eine mechanische Beschädigung der freiliegenden Enden der elektrischen Zuleitungen und stellt dabei sicher, dass die zum Signalanschluss bestimmten freien Enden der elektrischen Zuleitungen stets an der richtigen, bei der Herstellung auch ursprünglich eingestellten Position sind und auch dort bleiben. Dadurch lässt sich der Schallkopf bevorzugt automatisiert in ein Messsystem einbauen. Weiterhin erleichtern die im Schutzkragen vorhandenen Ausziehmittel eine Demontage des Schallkopfs aus seiner Einbauposition in einem Messrohr. Eine solche Demontage kann insbesondere nach einer längeren Betriebszeit des Schallkopfs schwierig sein, da sich an der Unterseite des Topfbodens und an der sich daran anschließenden Innenwand des Messrohres Verkrustungsablagerungen bilden können, die ein Entfernen des Schallkopfs, sei es zu Inspektionszwecken oder sei es zum Austausch wegen eines Defekts, erschweren. Die Ausziehmittel vereinfachen das Entfernen des Schallkopfs auch unter solchen widrigen Einbaubedingungen.

Gemäß einer weiteren günstigen Ausgestaltung sind die Ausziehmittel als mindestens eine in einer Kragenwand des Schutzkragens vorhandene Durchgangsöffnung ausgeführt. In eine solche Durchgangsöffnung kann insbesondere ein entsprechend ausgestaltetes Abziehwerkzeug eingesetzt werden, um den Schallkopf dann vorteilhafterweise ohne größeren Aufwand aus seiner Einbauposition herauszuziehen.

Gemäß einer weiteren günstigen Ausgestaltung sind die Ausziehmittel als zwei Durchgangsöffnungen ausgeführt, die in einer Kragenwand des Schutzkragens vorhanden sind und die miteinander fluchten. Dies vereinfacht das Entfernen des Schallkopfs aus seiner Einbauposition weiter. Wenn das Abziehwerkzeug in beide miteinander fluchtenden Durchgangsöffnungen eingreift, wird eine im Wesentlichen parallel zur Längsachse des Schallkopfs wirkende Auszugskraft aufgebracht, so dass es während des Herausziehens des Schallkopfs zu keinem Verkanten des Schallkopfs kommt, was andernfalls das Entfernen aus der Einbauposition erschweren würde.

Gemäß einer weiteren günstigen Ausgestaltung hat der Topf eine Topfwanddicke zwischen 0,1 mm und 1 mm, vorzugsweise zwischen 0,2 mm und 0,5 mm. Diese Dickenwerte gelten insbesondere sowohl für die Topfseitenwand als auch für den Topfboden. Jedenfalls handelt es sich um keine besonders große Topfwanddicke. Insofern ist der Topf insbesondere auch nur begrenzt mechanisch belastbar. Trotzdem ist der Schallkopf insgesamt mechanisch stabil, wozu insbesondere das Verstärkungsblech beiträgt. Die vergleichsweise niedrige Topfwanddicke spart Material und damit Kosten ein. Außerdem resultiert auch deshalb ein vorzugsweise relativ geringes Gesamtgewicht des Schallkopfs.

Gemäß einer weiteren günstigen Ausgestaltung hat das Verstärkungsblech eine Verstärkungsblechdicke (= Blechstärke) zwischen 0,5 mm und 5 mm, insbesondere zwischen 0,75 mm und 3 mm. Damit bewirkt es eine sehr gute mechanische Verstärkung, was insbesondere dann von Vorteil ist, wenn das zu erfassende Medium unter hohem Druck steht. Ein Verstärkungsblech mit einer Blechstärke aus den vorstehend genannten besonders günstigen Wertebereichen entlastet den Topf vorzugsweise sehr effizient.

Gemäß einer weiteren günstigen Ausgestaltung ist das Verstärkungsblech eine gestanzte Metallscheibe. Dies lässt sich sehr einfach, schnell und kostengünstig herstellen.

Gemäß einer weiteren günstigen Ausgestaltung hat das Verstärkungsblech eine zentrale Durchgangsöffnung, durch die sich der Kunststoff-Hauptkörper sowie die elektrische Zuleitungen hindurch erstrecken. Diese Geometrie des Verstärkungsblechs ist günstig, da sie zum einen die Durchführung der elektrischen Zuleitungen erlaubt, ohne zum anderen die mechanische Stabilisierungswirkung des Verstärkungsblechs maßgeblich zu schmälern.

Gemäß einer weiteren günstigen Ausgestaltung hat das Verstärkungsblech mehrere dezentrale Durchgangsöffnungen, welche mit dem Kunststoffmaterial des Kunststoff-Hauptkörpers ausgefüllt sind. Dadurch resultiert eine besonders stabile und innige Verbindung zwischen dem Verstärkungsblech und dem Kunststoff-Hauptkörper.

Gemäß einer weiteren günstigen Ausgestaltung ist das Verstärkungsblech mit dem Kunststoffmaterial des Kunststoff-Hauptkörpers umspritzt, so dass eine kombinierte Baueinheit aus dem Kunststoff-Hauptkörper und dem Verstärkungsblech gebildet ist. Ein derartiges Um- oder Einspritzen des Verstärkungsblechs mit dem Kunststoff des Kunststoff-Hauptkörpers erfolgt insbesondere mittels eines vorteilhafterweise automatisierten Spritzgussprozesses. Das Verschlussteil lässt sich so sehr einfach und effizient als Verbundbauteil (= kombinierte Baueinheit) herstellen.

Gemäß einer weiteren günstigen Ausgestaltung ist das Verstärkungsblech parallel zu dem elektromechanischen Schallwandlungselement angeordnet. Dann trägt das Verstärkungsblech besonders gut zum Schutz des elektromechanischen Schallwandlungselements als der Schlüsselkomponente des Schallkopfs und zur mechanischen Stabilität des Schallkopfs insgesamt bei. Der Aufbau des Schallkopfs wird so sehr sicher vor einer Beschädigung geschützt.

Weitere Merkmale, Vorteile und Einzelheiten der Erfindung ergeben sich aus der nachfolgenden Beschreibung von Ausführungsbeispielen anhand der Zeichnung. Es zeigt:
- Fig. 1: ein Ausführungsbeispiel eines erfindungsgemäßen Schallkopfs für einen Durchflussmesser in einer ersten Längsschnittdarstellung,
- Fig. 2: den Schallkopf gemäß Fig. 1 in einer perspektivischen Ansicht,
- Fig. 3: den Schallkopf gemäß Fig. 1 und 2 in einer zur ersten Längsschnittdarstellung gemäß Fig. 1 senkrechten zweiten Längsschnittdarstellung,
- Fig. 4: den Schallkopf gemäß Fig. 1 bis 3 in einer Explosionsdarstellung,
- Fig. 5: den Schallkopf gemäß Fig. 1 bis 4 in einer Draufsicht von oben,
- Fig. 6: eine Draufsicht auf ein Verstärkungsblech des Schallkopfs gemäß Fig. 1 bis 5, und
- Fig. 7: eine vergrößerte Detailansicht des in Fig. 1 mit VII markierten Ausschnitts.

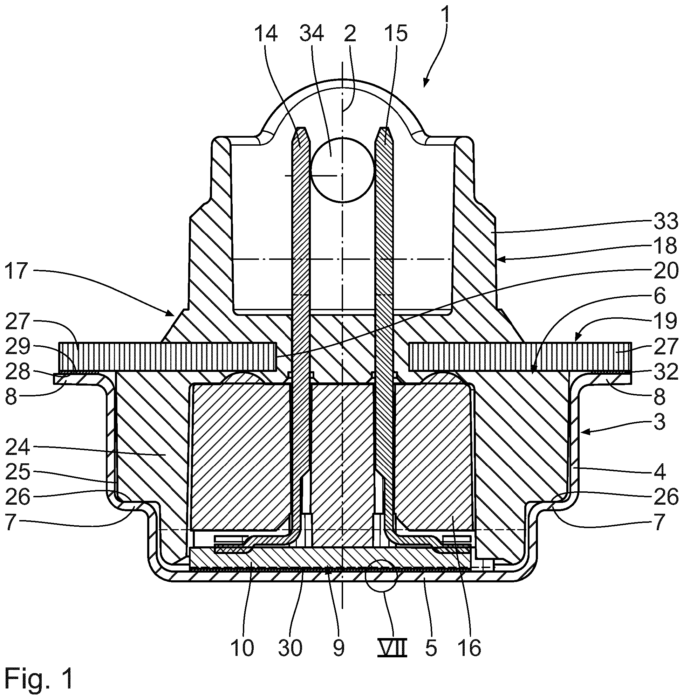

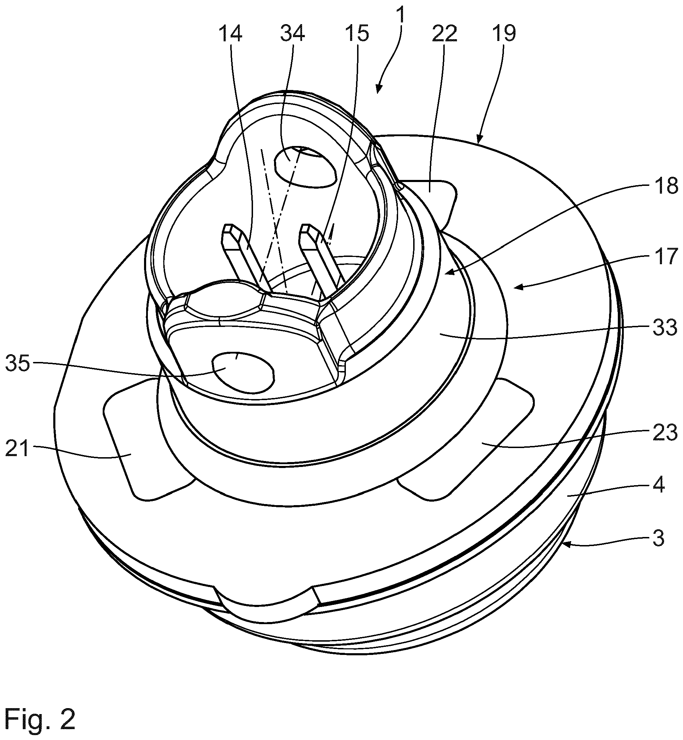

Einander entsprechende Teile sind in den Fig. 1 bis 7 mit denselben Bezugszeichen versehen. Auch Einzelheiten der im Folgenden näher erläuterten Ausführungsbeispiele können für sich genommen eine Erfindung darstellen oder Teil eines Erfindungsgegenstands sein.

In Fig. 1 bis 5 ist ein Ausführungsbeispiel eines Schallkopfs 1 gezeigt, der für einen Einbau in ein Messrohr eines Durchflussmessers zur schallbasierten Erfassung einer Durchflussmenge eines Mediums bestimmt ist. Bei dem Messrohr kann es sich beispielsweise um ein Armaturengehäuse handeln. Der Schallkopf 1 zeichnet sich durch einen einfachen Einbau aus, der vorteilhafterweise einen sehr montagefreundlichen, insbesondere vollautomatisierten Herstellungsprozess ermöglicht. Auf diese Weise lassen sich von dem Schallkopf 1 große Stückzahlen zu vergleichsweise niedrigen Kosten und mit einer vergleichsweise kurzen Fertigungsdauer herstellen.

Der Schallkopf 1 weist eine Längsachse 2 auf. In einer möglichen Ausführungsform ist der Schallkopf 1 im Wesentlichen rotationssymmetrisch in Bezug auf die Längsachse 2 ausgeführt. Dies ist aber nicht zwingend erforderlich. Andere Querschnittsgeometrien, beispielsweise eine in Bezug auf die Längsachse 2 im Wesentlichen quadratische oder rechteckige Querschnittsgeometrie, sind ebenfalls möglich.

Der Schallkopf 1 umfasst mehrere Teilkomponenten, so unter anderem einen Topf 3 aus einem metallischen, elektrisch leitfähigen Topfmaterial, beispielsweise aus einem Edelstahl. Der Topf 3 ist bei dem gezeigten Ausführungsbeispiel insbesondere ein tiefgezogenes Bauteil. Er weist eine insbesondere gestufte Topfseitenwand 4 und einen Topfboden 5 auf. Dem Topfboden 5 liegt eine Topföffnung 6 gegenüber. Die Topfseitenwand 4 hat eine Topfstufe 7. Außerdem mündet die Topfseitenwand 4 auf Höhe der Topföffnung 6 in einen insbesondere während Tiefziehvorgangs umgeformten Topf-Randbereich 8, welcher sich in seitliche Richtung weg von der Längsachse 2 erstreckt. Eine Oberflächennormale des Topf-Randbereichs 8 ist im Wesentlichen parallel zur Längsachse 2. Bei einer rotationssymmetrischen Geometrie des Schallkopfs 1 steht der Topf-Randbereich 8 radial vor bzw. ab. Unabhängig von der äußeren Geometrieform des Schallkopfs 1 umgibt der Topf-Randbereich 8 die Topföffnung 6 insbesondere voll umfänglich.

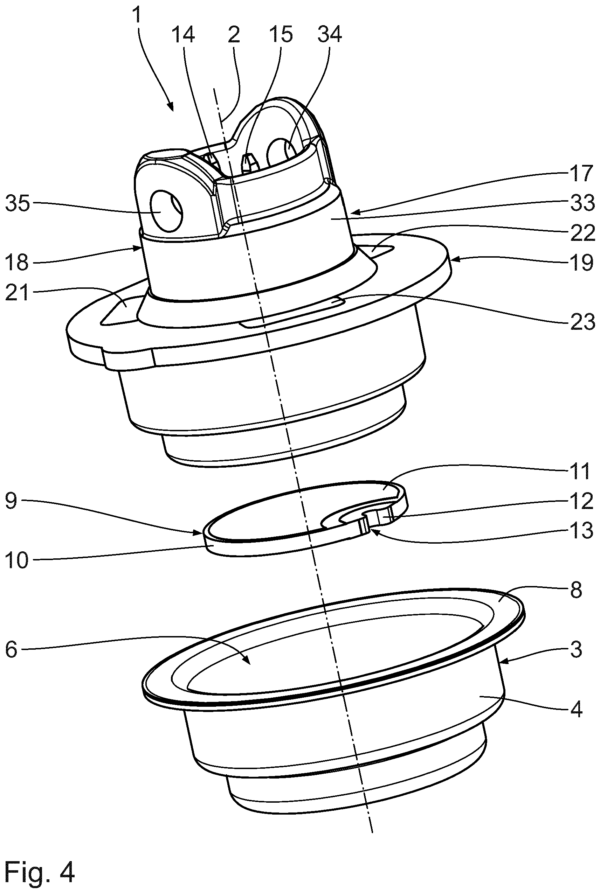

Als weitere Komponente weist der Schallkopf 1 ein elektromechanisches Schallwandlungselement 9 auf. Letzteres ist die Schlüsselkomponente für die schallempfangende und/oder schallsendende Funktion des Schallkopfs 1. Das elektromechanische Schallwandlungselement 9 ist auf die Innenseite des Topfbodens 5 geklebt. Es hat eine flache piezoelektrische Platte 10 mit ebener Ober- und Unterseite, die beide im Wesentlichen senkrecht zur Längsachse 2 orientiert sind. An der Ober- und Unterseite ist die piezoelektrische Platte 10 jeweils mit einer Elektrode 11 bzw. 12 versehen, wobei die an der Unterseite angeordnete Elektrode 12 im Bereich einer seitlichen Aussparung 13 der piezoelektrischen Platte 10 über den Rand der piezoelektrischen Platte 10 nach oben bis zur Oberseite gezogen ist (siehe hierzu Fig. 4). Die an der Oberseite vorgesehene Elektrode 11 hat in diesem Bereich eine Aussparung und erstreckt sich nicht bis dorthin, so dass zwischen dem nach oben gezogenen Anteil der Elektrode 12 von der Unterseite und der Elektrode 11 an der Oberseite ein Isolationsabstand gegeben ist. Die seitliche Aussparung 13 dient auch zur insbesondere automatisiert durchgeführten positionsrichtigen Platzierung des elektromechanischen Schallwandlungselements 9 auf dem Topfboden 5.

Der Topf 3 ist ein einstückiges Tiefziehbauteil. Insbesondere sind die Topfseitenwand 4 und der Topfboden 5 also einstückig miteinander verbunden. Sie bestehen aus dem gleichen Material. Dementsprechend liegt zwischen ihnen eine Stoffverbindung vor. Weiterhin ist der Topf 3 an seiner beim Einbau im Messrohr dem zu erfassenden Medium zugewandten Unterseite durch den Topfboden 5 geschlossen. Im eingebauten Zustand kapselt der Topf 3 die Innenseite des Topfs 3 und die darin befindlichen Komponenten sicher von dem zu erfassenden Medium ab, wobei das Medium direkt an der außen liegenden Unterseite des Topfbodens 5 vorbeiströmt. Der Schallkopf 1 ist nämlich insbesondere in eine Durchgangsöffnung des Messrohres einzusetzen und kommt somit an seiner Unterseite mit dem zu erfassenden Medium in Kontakt.

Weiterhin hat der Schallkopf 1 zwei elektrische Zuleitungen 14 und 15, mittels derer die beiden Elektroden 11 und 12 elektrisch kontaktiert sind. Die elektrischen Zuleitungen 14 und 15 sind beim gezeigten Ausführungsbeispiel als Federkontaktstifte ausgeführt. Ihre sich in Richtung der Längsachse 2 erstreckenden Zuführungsabschnitte sind durch ein rückseitig auf das elektromechanische Schallwandlungselement 9 aufgesetztes Dämpfungselement 16 (= backing) hindurchgeführt. Das Dämpfungselement 16 besteht aus einem Elastomer, beispielsweise aus Viton. Es ist in gewissem Umfang kompressibel und übt im zusammengepressten Zustand eine Anpresskraft auf das elektromechanische Schallwandlungselement 9 sowie auf die umgebogenen Abschnitte der Federkontaktstifte der elektrischen Zuleitungen 14 und 15 aus, welche dadurch an die jeweiligen elektrischen Kontaktstellen auf den Elektroden 11 und 12 gedrückt werden. Das Dämpfungselement 16 ist ebenfalls eine Komponente des Schallkopfs 1.

Eine weitere Komponente des Schallkopfs 1 ist ein Verschlussteil 17, das in den Topf 3 eingesetzt ist und die Topföffnung 6 verschließt. Das Verschlussteil 17 ist das tragende Bauteil, das außer zum Verschließen der Topföffnung 6 vor allem auch zur Gewährleistung der mechanischen Stabilität des Schallkopfs 1 insgesamt dient. Es ist ein Verbundbauteil, das sich aus einem Kunststoff-Hauptkörper 18 und einem Verstärkungsblech 19 zusammensetzt. Das insbesondere metallische Verstärkungsblech 19 ist teilweise in dem Kunststoff-Hauptkörper 18 eingebettet. Es ist zu einem Teil mit dem Kunststoff des Kunststoff-Hauptkörpers 18 umspritzt. Dieses Um- oder Einspritzen des Verstärkungsblechs 19 mit dem Kunststoff des Kunststoff-Hauptkörpers 18 erfolgt insbesondere mittels eines vorteilhafterweise automatisierten Spritzgussprozesses. Am Ende dieses Spritzgussprozesses liegt das Verschlussteil 17 als Verbundbauteil vor.

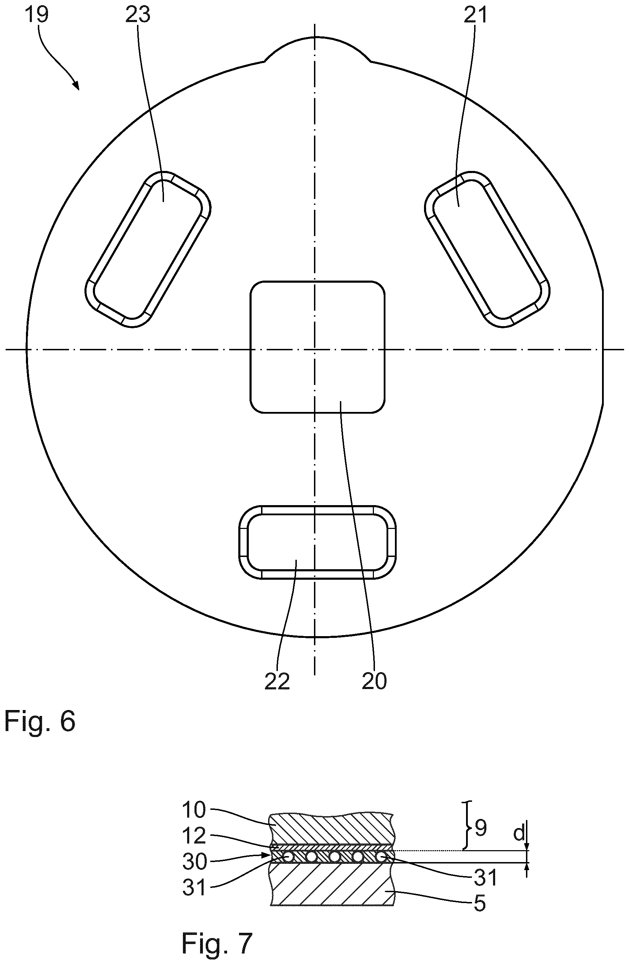

Eine Draufsicht auf das (noch nicht mit Kunststoff umspritzte) Verstärkungsblech 19 ist in Fig. 6 gezeigt. Es enthält eine zentrale Durchgangsöffnung 20 und drei weitere in Umfangsrichtung gleichmäßig verteilt angeordnete Randöffnungen 21, 22, 23, welche auch als dezentrale Durchgangsöffnungen verstanden werden können. Letztere sind mit dem Kunststoff des Kunststoff-Hauptkörpers 18 ausgefüllt, so dass eine innige Verbindung zwischen diesen beiden Teilkomponenten resultiert. Im Bereich der zentralen Durchgangsöffnung 20 sind die elektrischen Zuleitungen 14, 15 mit ihren Zuführungsabschnitten durch das Verstärkungsblech 19 hindurchgeführt. Ansonsten erstreckt sich auch der Kunststoff des Kunststoff-Hauptkörpers 18 durch die zentrale Durchgangsöffnung 20 hindurch, was die Verbundfestigkeit weiter erhöht.

Das Verschlussteil 17 ist mit einem Innenteil 24 des Kunststoff-Hauptkörpers 18 in den Topf 3 eingesetzt. Der Innenteil 24 umgibt seitlich das Dämpfungselement 16 und zumindest teilweise auch das elektromechanische Schallwandlungselement 9. Von oben übt das eingesetzte Verschlussteil 17 auf das Dämpfungselement 16 Druck aus, so dass Letzteres komprimiert wird. Das Verschlussteil 17 hat im Bereich seines Innenteils 24 eine Verschlussteilseitenwand 25, die mit einer zur Topfstufe 7 korrespondierenden Verschlussteilstufe 26 versehen ist. Die Topfstufe 7 und die Verschlussteilstufe 26 liegen im endmontierten Zustand des Schallkopfs 1 unmittelbar aneinander an.

Oberhalb des Innenteils 24 mit seiner Verschlussteilseitenwand 25 ist das Verstärkungsblech 19 angeordnet. Es bildet einen seitlich vorstehenden und komplett umlaufenden Verbindungskragen 27 des Verschlussteils 17 und ist mit dem Topf-Randbereich 8 fest verbunden, beim gezeigten Ausführungsbeispiel verklebt. Der Verbindungskragen 27 steht seitlich über die Verschlussteilseitenwand 25 vor. Im Bereich des Verbindungskragens 27 hat das Verstärkungsblech 19 eine Verschlussteil-Verbindungsfläche 28, die mit einer im Topf-Randbereich 8 vorhandenen korrespondierenden Topf-Verbindungsfläche 29 verbunden, insbesondere verklebt ist. Die Verbindung erfolgt jeweils zwischen zwei Metallkomponenten und ist deshalb besonders stabil und beständig.

Das Verstärkungsblech 19 des Verschlussteils 17 dient zur mechanischen Verstärkung, was insbesondere dann von Vorteil ist, wenn das mittels des Schallkopfs 1 zu erfassende Medium unter hohem Druck steht. In der Praxis können bei einem Einsatz in einem flüssigen Medium im Normalbetrieb Druckwerte im Bereich zwischen etwa 16 bar bis etwa 25 bar auftreten. Kurzzeitig kann es sogar zu Druckspitzen im Bereich zwischen etwa 24 bar bis etwa 50 bar kommen. Dann verhindert das Verstärkungsblech 19 eine unerwünschte Verbiegung des Schallkopfs 1 und insbesondere des darin enthaltenen elektromechanischen Schallwandlungselements 9, so dass die volle Funktionsfähigkeit auch bei derartig hohen Druckwerten erhalten bleibt, obwohl der die Außenhülle darstellende Topf 3 nur ein tiefgezogenes Bauteil mit vergleichsweise geringer Topfwanddicke ist. Die Topfwanddicke des Topfs 3 liegt beispielsweise lediglich bei etwa zwischen 0,25 mm und 0,45 mm. Trotzdem bleibt die mechanische Stabilität gewährleistet, was insbesondere aufgrund des Verstärkungsblechs 19 erreicht wird. Außer einer Beschädigung des Schallkopfs 1 verhindert das Verstärkungsblech 19 auch, dass es beispielsweise wegen einer ansonsten bei hohen Druckbeaufschlagungen möglichen Verformung der Außenkontur des Schallkopfs 1 zu einer Leckage an der Stelle im das Medium führenden Rohrleitungssystem kommt, an der der Schallkopf 1 eingesetzt ist.

Auch die an der Topfstufe 7 anliegende Verschlussteilstufe 26 dient zur Stabilisierung. Sie nimmt einen Teil des vom Medium ausgeübten Drucks auf und leitet ihn an das Verstärkungsblech 19 weiter. Eine weitere vorteilhafte Funktion der Topfstufe 7 und der daran anliegenden Verschlussteilstufe 26 besteht darin, dass hierdurch ein Endanschlag bei der Fixierung mit Klebstoff gebildet wird. Außerdem kann an der Außenseite der Topfstufe 7 ein im Betrieb des Schallkopfs 1 gegebenenfalls erforderlicher Schallreflektor beim Einbau in das Messrohr angesetzt werden. Auch dies ist vorteilhaft.

Das Verstärkungsblech 19 hat beim gezeigten Ausführungsbeispiel eine Stärke von etwa 1 mm. Damit ist es in der Lage, die während des Betriebs auftretenden Druckkräfte aufzunehmen. Das Verstärkungsblech 19 ist eine gestanzte Metallscheibe. Es ist mit dem Kunststoffmaterial des Kunststoff-Hauptkörpers 18 zumindest teilweise umspritzt, so dass insgesamt eine kombinierte Baueinheit aus dem Kunststoff-Hauptkörper 18 und dem Verstärkungsblech 19 gebildet ist. Das Verstärkungsblech 19 ist im montierten Zustand im Wesentlichen parallel zu dem plattenförmigen elektromechanischen Schallwandlungselement angeordnet, so dass das Verstärkungsblech 19 sehr gut zum Schutz dieser Schlüsselkomponente und zur mechanischen Stabilität des Schallkopfs 1 insgesamt beitragen kann. Kräfte, die ansonsten zu einer Verbiegung des Topfbodens 5 und des auf seiner Innenseite angeordneten elektromechanischen Schallwandlungselements 9 führen würden, werden durch das Verstärkungsblech 19 aufgenommen. Der Aufbau des Schallkopfs 1 behält seine ursprüngliche Form und wird sicher vor einer Beschädigung geschützt.

Zwischen dem elektromechanischen Schallwandlungselement 9 und der Innenseite des Topfbodens 5 befindet sich eine erste Klebstoffschicht, die die feste Verbindung zwischen diesen beiden Komponenten bewirkt. Diese erste Klebstoffschicht ist elektrisch isolierend. Sie enthält bei dem gezeigten Ausführungsbeispiel als Hauptkomponente einen Epoxidkleber, der insbesondere zusätzlich mit mechanisch stabilen Abstandshalteelementen 31 in Form von kleinen Glaskügelchen versehen ist. Diese in der vergrößerten Ausschnittsdarstellung gemäß Fig. 7 ersichtlichen Abstandshalteelemente 31 stellen sicher, dass ein Abstand d zwischen dem elektromechanischen Schallwandlungselement 9 und dem Topfboden 5 an jeder Stelle in etwa 100 µm beträgt. Der Abstand d ist die Schichtdicke der ersten Klebstoffschicht 30, welche aufgrund ihrer Zusammensetzung aus der Matrix aus dem eigentlichen Klebstoff, hier dem Epoxidkleber, und den darin eingebetteten Abstandshalteelementen 31 auch als Verbundschicht verstanden werden kann. Sowohl der eigentliche Klebstoff als auch die Abstandshalteelemente 31 sind elektrisch isolierend, so dass auch die erste Klebstoffschicht 30 insgesamt diese Eigenschaft aufweist. Insofern besteht beim Einsatz des Schallkopfs 1 keine elektrisch leitende Verbindung zwischen dem an der Außenseite des elektrisch leitfähigen Topfbodens 5 vorbeiströmenden Medium und dem an der Innenseite des Topfbodens 5 mittels der elektrisch isolierenden ersten Klebstoffschicht 30 befestigten elektromechanischen Schallwandlungselement 9. Dadurch verringert sich die Störanfälligkeit des Messsystems insgesamt. Es kann ein stärkeres Nutzsignal zur Auswertung erzeugt werden.

Außerdem vereinfacht sich durch diese Maßnahme auch die Energieversorgungsanbindung der Steuereinheit, an die der Schallkopf 1 zum Betrieb angeschlossen wird. Aufgrund der elektrisch isolierend ausgeführten ersten Klebstoffschicht 30 besteht zwischen dem elektromechanischen Schallwandlungselement 9 und dem metallischen Topf 3 keine elektrisch leitende Verbindung. Damit ist das elektromechanische Schallwandlungselement 9 inklusive seiner elektrischen Zuleitungen 14, 15 auch vom an der Außenseite des Topfbodens 5 während des Betriebs des Schallkopfs 1 vorbei strömenden zu erfassenden Medium galvanisch getrennt. Diese galvanische Trennung wird dabei alleine durch den günstigen internen Aufbau des Schallkopfs 1, insbesondere durch die elektrisch isolierende erste Klebstoffschicht 30, erreicht. Insofern kann in der Energieversorgungsanbindung der Steuereinheit des Schallkopfs 1 auf ein ansonsten zur galvanischen Trennung erforderliches Zusatzbauteil, beispielsweise in Form eines Optokopplers, verzichtet werden. Dies trägt zur Kostenreduktion des Messsystems insgesamt bei.

Darüber hinaus sind die Topfseitenwand 4 und das Innenteil 24 des in den Topf 3 eingesetzten Verschlussteils 17 mittels einer zweiten Klebstoffschicht 32 fest miteinander verbunden. Diese zweite Klebstoffschicht 32 befindet sich insbesondere zwischen der Verschlussteil-Verbindungsfläche 28 am Verbindungskragen 27 des Verschlussteils 17 und der Topf-Verbindungsfläche 29 am Topf-Randbereich 8. Dort gewährleistet es eine dauerhafte und dichte Verbindung zwischen dem Topf 3 und dem Verschlussteil 17. Die innerhalb des Topfs 3 angeordneten übrigen Komponenten sind somit sehr gut gegen widrige äußere Umgebungseinflüsse abgeschirmt. Die zweite Klebstoffschicht 32 hat somit insbesondere auch eine abdichtende Funktion. Insbesondere ist dadurch ein Schutz vor Eindringen von Staub, anderem Schmutz und Wasser gegeben.

Auch die zweite Klebstoffschicht 32 kann als Epoxidkleber ausgeführt sein. Die Klebstoffe der ersten Klebstoffschicht 30 und der zweiten Klebstoffschicht 32 können allerdings unterschiedlich ausgeführt sein. Vorteilhafterweise haben sie aber dennoch die gleichen Härtungsbedingungen, also insbesondere gleiche Härtungszeiten, gleiche Härtungstemperaturen und gleichen Härtungsdruck. Insofern können die erste und die zweite Klebstoffschicht 30 bzw. 32 während der Herstellung gleichzeitig ausgehärtet werden, wodurch sich die Produktionszeit verkürzt.

Aufgrund der festen Klebeverbindung zwischen dem Topf 3 und dem Verschlussteil 17 ist der Schallkopf 1 ein nicht zerlegbares Kombinationsbauteil, dessen Einzelkomponenten sowohl während des Fertigungsvorgangs aber vor allem auch danach stets in der gewünschten Position bleiben. Dies erleichtert den Einbau des Schallkopfs 1 in ein Messsystem. Fehlmontagen können auf diese Weise ausgeschlossen werden. Demgegenüber kann es bei einem nur lose zusammengesetzten und auch wieder zerlegbaren Aufbau dazu kommen, dass Komponenten (nachträglich) verrutschen und sich dann nicht mehr in der korrekten Position befinden, wodurch Fehler auftreten können.

Das Verschlussteil 17 setzt sich auf der vom in den Topf 3 eingesetzten Innenteil 34 abgewandten Seite des Verstärkungsblechs 19 fort. In diesem außerhalb des Topfs 3 befindlichen Außenbereich hat das Verschlussteil 17 einen Schutzkragen 33, welcher über die verschlossene Topföffnung 6 vorsteht und die elektrischen Zuleitungen 14 und 15 in diesem Außenbereich umgibt. Eine Kragenwand des Schutzkragens 33 weist zwei miteinander fluchtende Durchgangsöffnungen 34, 35 auf. Diese beiden Durchgangsöffnungen 34, 35 sind Ausziehmittel, die das Entfernen des Schallkopfs aus seiner Einbauposition in dem Messrohr erleichtern. Ein derartiges Entfernen kann insbesondere nach einer längeren Betriebszeit des Schallkopfs 1 schwierig sein, da sich an der Unterseite des Topfbodens 5 und an der sich daran anschließenden Innenwand des Messrohres Verkrustungsablagerungen bilden können, die ein Entfernen des Schallkopfs 1, sei es zu Inspektionszwecken oder sei es zum Austausch wegen eines Defekts, erschweren. Die Durchgangsöffnungen 34, 35 ermöglichen das Entfernen des Schallkopfs 1 auch unter solchen widrigen Einbaubedingungen, indem ein entsprechendes Abziehwerkzeug in beide Durchgangsöffnungen 34, 35 eingesetzt wird.

Der Schutzkragen 33 dient ansonsten dem Schutz der darin angeordneten Endabschnitte der elektrischen Zuleitungen 14, 15. Auf diese Weise wird verhindert, dass die freiliegenden Enden der elektrischen Zuleitungen 14, 15 beschädigt oder auch nur umgebogen werden, was andernfalls den Einbau des Schallkopfs 1 in ein Messsystem erschweren oder im ungünstigsten Fall sogar unmöglich machen würde. Der Schutzkragen 33 stellt dagegen sicher, dass die zum Signalanschluss vorgesehenen freien Enden der elektrischen Zuleitungen 14, 15 stets an ihrer vorgesehenen Position sind. Dadurch wird insbesondere auch eine automatisierte Montage des Schallkopfs 1 in ein Messsystem ermöglicht.

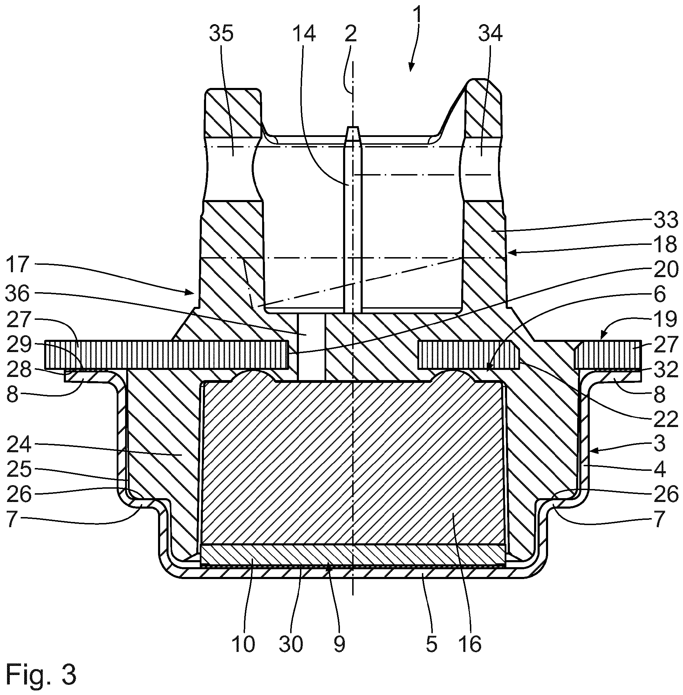

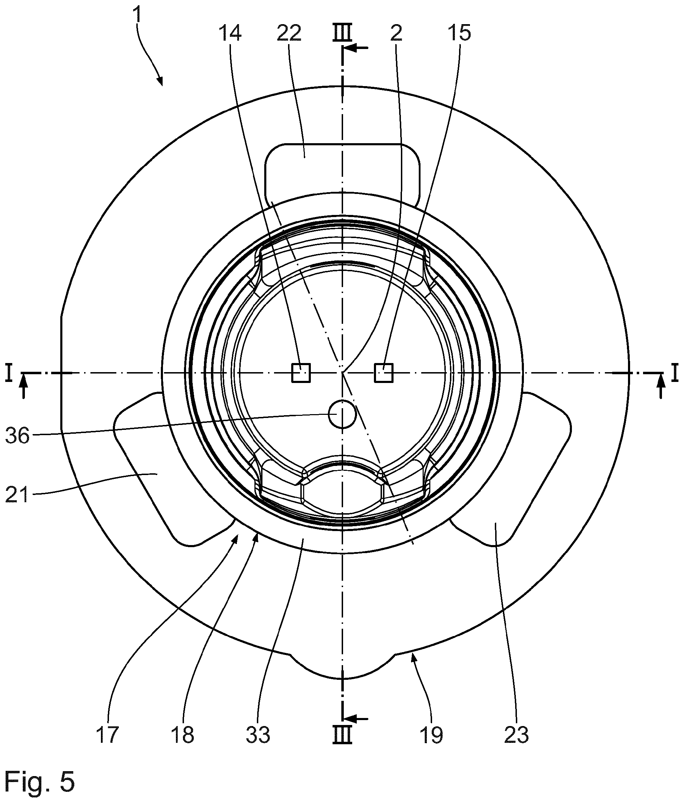

Wie aus Fig. 3 und 5 ersichtlich, hat das Verschlussteil 17 auch eine Entlüftungsbohrung 36. Diese Entlüftungsbohrung 36 verläuft innerhalb des Kunststoff-Hauptkörpers 18 in dem Bereich, der die zentrale Durchgangsöffnung 20 des Verstärkungsblechs 19 durchsetzt. Diese Entlüftungsbohrung 36 dient insbesondere dazu, Luft und/oder Gase, die während der Herstellung und auch später während des Betriebs des Schallkopfs 1 im Inneren des Topfs 3 vorhanden sind oder sich bilden, entweichen können. Dies gilt insbesondere für den Zeitraum des Klebeprozesses zur Herstellung der dauerhaften Verbindung zwischen dem Topf 3 und dem Verschlussteil 17. Überschüssige Luft und Gase, die sich im Zuge der Herstellung der Klebstoffverbindung bilden, können auf diese Weise entweichen und führen dann nicht zu einem unerwünschten Luft- bzw. Gaseinschluss im Inneren des Topfs 3, wodurch andernfalls die Funktionsweise beeinträchtigt werden könnte. Bei Bedarf kann in einer nicht gezeigten alternativen Ausführungsform auch das Dämpfungselement 16 mit mindestens einer solchen Entlüftungsbohrung ausgestattet sein.

Insgesamt lässt sich der Schallkopf 1 vorteilhafterweise voll automatisiert und damit sehr kosteneffizient und auch in großen Stückzahlen herstellen. Der als Tiefziehbauteil ausgeführte Topf 3 und das als Kunststoff-Spritzgussbauteil ausgeführte Verschlussteil 17 sind Komponenten, deren Herstellung in bekannter Weise automatisiert durchgeführt werden kann. Der resultierende Schallkopf 1 weist alle für seinen Einsatzzweck erforderlichen akustischen und mechanischen Eigenschaften auf, obwohl er verglichen mit früheren Bauformen, die z.B. ein sehr schweres Messing-Gehäuse haben, ein deutlich geringeres Gewicht aufweist.

## Patentansprüche

1. Schallkopf zum Einbau in ein Messrohr eines Durchflussmessers zur schallbasierten Erfassung einer Durchflussmenge eines Mediums aufweisend eine Längsachse (2) sowie
a) einen Topf (3) aus einem metallischen Topfmaterial mit einer Topfseitenwand (4), einem zu durchschallenden Topfboden (5) und einer dem Topfboden (5) gegenüberliegenden Topföffnung (6),
b) ein elektromechanisches Schallwandlungselement (9), das auf eine Innenseite des Topfbodens (5) geklebt ist,
c) zwei aus der Topföffnung (6) herausführende elektrische Zuleitungen (14, 15) zur elektrischen Kontaktierung des elektromechanischen Schallwandlungselements (9),
d) ein Verschlussteil (17), das in den Topf (3) eingesetzt ist und die Topföffnung (6) verschließt,
wobei,
e) die Topfseitenwand (4) auf Höhe der Topföffnung (6) in einen umgebogenen Topf-Randbereich (8) mündet, welcher sich in seitliche Richtung weg von der Längsachse (2) erstreckt,
f) die Topfseitenwand (4) eine Topfstufe (7) aufweist und das Verschlussteil (17) in einer Verschlussteilseitenwand (25) eine zur Topfstufe (7) korrespondierende Verschlussteilstufe (26) aufweist, wobei die Topfstufe (7) und die Verschlussteilstufe (26) unmittelbar aneinander anliegen,
g) das Verschlussteil (17) einen seitlich vorstehenden und komplett umlaufenden Verbindungskragen (27) hat, der mit dem umgebogenen Topf-Randbereich (8) der Topfseitenwand (4) fest verbunden ist, und
h) der Topf (3) im in ein Messrohr eingebauten Zustand des Schallkopfs die Innenseite des Topfs (3) von dem Medium abkapselt.

2. Schallkopf nach Anspruch 1, **dadurch gekennzeichnet, dass** das Verschlussteil (17) so innerhalb des Topfs (3) platziert ist, dass es Druck auf das elektromechanische Schallwandlungselement (9) ausübt.

3. Schallkopf nach Anspruch 1 oder 2, **dadurch gekennzeichnet, dass** die Verbindung zwischen dem Verbindungskragen (27) und dem Topf-Randbereich (8) der Topfseitenwand (4) eine Klebeverbindung oder eine Schweißverbindung ist.

4. Schallkopf nach einem der vorhergehenden Ansprüche, **dadurch gekennzeichnet, dass** das Verschlussteil (17) einen Kunststoff-Hauptkörper (18) und ein Verstärkungsblech (19) hat, wobei das Verstärkungsblech (19) zumindest zu einem Teil in dem Kunststoff-Hauptkörper (18) eingebettet ist.

5. Schallkopf nach Anspruch 4, **dadurch gekennzeichnet, dass** sich das Verstärkungsblech (19) bis in den Verbindungskragen (27) erstreckt und dort eine Verschlussteil-Verbindungsfläche (28) bildet, die mit einer im Randbereich (8) der Topfseitenwand (4) vorhandenen korrespondierenden Topf-Verbindungsfläche (29) verbunden ist.

## Claims

1. Sound head for installation into a measurement tube of a flow meter for sound-based detection of a flow rate of a medium, having a longitudinal axis (2), and having
a) a pot (3) composed of a metallic pot material, which has a pot side wall (4), a pot base (5) through which sound is to be passed and a pot opening (6) which is opposite the pot base (5),
b) an electromechanical sound transducer element (9), which is adhesively bonded to an inner side of the pot base (5),
c) two electrical feed lines (14, 15), which lead out of the pot opening (6) and serve for the electrical contacting of the electromechanical sound transducer element (9),
d) a closure part (17), which is inserted into the pot (3) and closes off the pot opening (6),
wherein
e) the pot side wall (4), at the height of the pot opening (6), opens into a bent-over pot edge region (8) which extends laterally away from the longitudinal axis (2),
f) the pot side wall (4) has a pot step (7), and the closure part (17) has in a closure part side wall (25) a closure part step (26) which corresponds to the pot step (7), wherein the pot step (7) and the closure part step (26) abut directly on one another,
g) the closure part (17) has a laterally projecting and fully encircling connecting collar (27) which is connected fixedly to the bent-over pot edge region (8) of the pot side wall (4), and
h) the pot (3), in the state in which the sound head is installed into a measurement tube, encapsulates the inner side of the pot (3) with respect to the medium.

2. Sound head according to Claim 1, **characterized in that** the closure part (17) is placed within the pot (3) such that said closure part exerts pressure on the electromechanical sound transducer element (9).

3. Sound head according to Claim 1 or 2, **characterized in that** the connection between the connecting collar (27) and the pot edge region (8) of the pot side wall (4) is an adhesive connection or a welded connection.

4. Sound head according to one of the preceding claims, **characterized in that** the closure part (17) has a plastic main body (18) and a reinforcement plate (19), wherein the reinforcement plate (19) is at least partly embedded in the plastic main body (18).

5. Sound head according to Claim 4, **characterized in that** the reinforcement plate (19) extends as far as the connecting collar (27) and, there, forms a closure part connecting surface (28) which is connected to a corresponding pot connecting surface (29) which is present in the edge region (8) of the pot side wall (4).

## Revendications

1. Tête à ultrasons destinée à être installée dans un tube de mesure d'un débitmètre pour la détection sonore du débit d'un fluide, présentant un axe longitudinal (2) et
a) un pot (3) constitué d'une matière de pot métallique comportant une paroi latérale de pot (4), un fond de pot (5) à traverser par le son et une ouverture de pot (6) opposée au fond de pot (5),
b) un élément de transduction sonore électromécanique (9) qui est collé à une face intérieure du fond de pot (5),
c) deux câbles d'alimentation électrique (14, 15) sortant de l'ouverture de pot (6) pour établir le contact électrique avec l'élément de transduction sonore électromagnétique (9),
d) une pièce de fermeture (17) qui est insérée dans le pot (3) et ferme l'ouverture de pot (6),
e) la paroi latérale de pot (4) s'ouvrant au niveau de l'ouverture de pot (6) dans une zone de bord de pot pliée (8) qui s'étend dans la direction latérale s'éloignant de l'axe longitudinal (2),
f) la paroi latérale de pot (4) comportant un étage de pot (7) et la pièce de fermeture (17) comportant, dans une paroi latérale de pièce de fermeture (25), un étage de pièce de fermeture (26) correspondant à l'étage de pot (7), l'étage de pot (7) et l'étage de pièce de fermeture (26) étant directement adjacents l'un à l'autre,
g) la pièce de fermeture (17) comportant un collier connecteur (27) faisant saillie latéralement et entièrement circonférentielle qui est rigidement relié à la zone de bord de pot (8) repliée de la paroi latérale de pot (4), et
h) le pot (3) séparant la face intérieure du pot (3) du fluide lorsque la tête à ultrasons est installée dans un tube de mesure.

2. Tête à ultrasons selon la revendication 1, **caractérisée en ce que** la pièce de fermeture (17) est placée à l'intérieur du pot (3) de telle manière qu'elle exerce une pression sur l'élément de transduction sonore électromécanique (9).

3. Tête à ultrasons selon la revendication 1 ou 2, **caractérisée en ce que** la liaison entre le collier connecteur (27) et la zone de bord de pot (8) de la paroi latérale de pot (4) est une liaison adhésive ou une liaison soudée.

4. Tête à ultrasons selon l'une des revendications précédentes, **caractérisée en ce que** la pièce de fermeture (17) comporte un corps principal (18) en matière plastique et une tôle de renforcement (19), la tôle de renforcement (19) étant au moins en partie intégrée dans le corps principal (18) en matière plastique.

5. Tête à ultrasons selon la revendication 4, **caractérisée en ce que** la tôle de renforcement (19) s'étend dans le collier connecteur (27) et y forme une surface de liaison (28) de la pièce de fermeture, laquelle surface est reliée à une surface de liaison de pot (29) correspondante existant dans la zone de bord (8) de la paroi latérale de pot (4).
